# EUROPÄISCHE PATENTSCHRIFT

(11) **EP 2 052 006 B1**
(45) Veröffentlichungstag und Bekanntmachung des Hinweises auf die Patenterteilung: **12.06.2013**
(21) Anmeldenummer: 07786157.3
(22) Anmeldetag: 18.07.2007
(51) Int. Cl.: C08G 61/00, C08G 61/02, C08G 61/10, C08G 61/12, C08G 83/00

(54) **KONJUGIERTE POLYMERE, VERFAHREN ZU DEREN HERSTELLUNG SOWIE DEREN VERWENDUNG**
CONJUGATED POLYMERS, PROCESS FOR THEIR PREPARATION AND THEIR USE
POLYMÈRES CONJUGUÉS, LEUR PROCÉDÉ DE FABRICATION ET LEUR UTILISATION

(30) Priorität: 17.08.2006 DE 102006038683
(43) Veröffentlichungstag der Anmeldung: 29.04.2009
(73) Patentinhaber: Merck Patent GmbH, 64293 Darmstadt (DE)
(72) Erfinder: SCHULTE, Niels, 65779 Kelkheim (DE); SCHEURICH, René Peter, 64846 Gross-Zimmern (DE); PAN, Junyou, 60435 Frankfurt (DE)
(86) Internationale Anmeldenummer: PCT/EP2007/006383
(87) Internationale Veröffentlichungsnummer: WO 2008/019744

(56) Entgegenhaltungen:
- EP-A- 1 074 600
- WO-A-2005/014689
- WO-A-2005/030827
- WO-A-2005/078002
- WO-A-2005/104264
- DE-A1- 10 357 317
- US-A1- 2004 062 930
- US-A1- 2004 214 036
- FRANK UCKERT: "Neue l sliche Poly(para-phenylen)-Derivate mit überbrückten Biphenyl-U" DISSERTATION ZUR ERLANGUNG DES GRADES DOKTOR DER NATURWISSENSCHAFTEN IM FACHBEREICH CHEMIE UND PHARMAZIE DER JOHANNES GUTENBERG-UNIVERSITAET IN MAINZ, 1998, Seiten 1-210, XP002306981

## Beschreibung

Die vorliegende Erfindung betrifft konjugierte Polymere enthaltend Dihydrophenanthren-Struktureinheiten, Verfahren zu ihrer Herstellung sowie ihre Verwendung in elektronischen Bauteilen, insbesondere in polymeren organischen Leuchtdioden, sowie solche Polymere enthaltende Bauteile und Leuchtdioden.

Konjugierte Polymere werden zur Zeit intensiv als vielversprechende Materialien in PLEDs (Polymer Light Emitting Diodes) untersucht. Ihre einfache Verarbeitung im Gegensatz zu SMOLEDs (Small Molecule Organic Light Emitting Diodes) verspricht eine kostengünstigere Herstellung von entsprechenden Leuchtdioden.

Da PLEDs meist nur aus einer lichtemittierenden Schicht bestehen, werden Polymere benötigt die sämtliche Funktionen einer OLED (Ladungsinjektion, Ladungstransport, Rekombination) in sich vereinigen können. Daher werden während der Polymerisation unterschiedlichste Monomere eingesetzt, die entsprechende Funktionen übernehmen.

SMOLEDs sind im Gegensatz zu PLEDs aus mehreren Schicht aufgebaut, welche die verschiedenen Funktionen erfüllen. Auch hier tritt eine lichtemittierende Schicht auf, welche den Emitter enthält.

Bei PLEDs werden für die Erzeugung aller drei Emissionsfarben üblicherweise bestimmte Comonomere in die entsprechenden Polymere einpolymerisiert (vgl. z.B. WO 00/46321, WO 03/020790 und WO 02/077060). So ist dann in der Regel - ausgehend von einem blau emittierenden Grundpolymer ("backbone") - die Erzeugung der beiden anderen Primärfarben Rot und Grün möglich.

Die wichtigsten Kriterien einer OLED sind Effizienz, Farbe, Lebensdauer und Prozessierbarkeit. Diese Eigenschaften werden maßgeblich durch die Kombination von Backbone und Emitter bestimmt.

Die Lebensdauer hängt von der Backbonestabilität ab, welche wiederum durch den Ladungsträgertransport, insbesondere den Elektronentransport, beeinflusst wird.

Gemäß dem Stand der Technik werden heute vor allem konjugierte Polymere auf Basis von Fluorenen, Indenofluorenen, Spirobifluorenen, Phenanthrenen und Dihydrophenanthrenen synthetisiert, um blau lumineszierende organische Leuchtdioden herstellen zu können. Dabei finden zunehmend Zweischichtaufbauten Akzeptanz, bei denen eine Emissionsschicht auf eine Injektionsschicht aufgebracht ist.

Polymere enthaltend Dihydrophenanthren-Einheiten werden z.B. in der WO 05/14689 A2, in der WO 2005/078002 A1, in der WO 2005/030827A1 und in der WO 2005/104264 A1 offenbart. In diesen Dokumenten werden jedoch nur Polymere mit Dihydrophenanthren-Einheiten offenbart, mit Substituenten in der 9,10-Position, die Sauerstoffatome aufweisen.

In der EP 1 074 600 A2 wird ein Polymer mit einer Dihydrophenanthren-Einheit offenbart, welche zwei Wasserstoff-Substituenten in der 9,10-Position enthält.

Weitere Polymere, die Dihydrophenanthren-Einheiten enthalten, werden in der DE 10357317 A1, in der US 2004/214036 A1 und in der US 2004/062930 A1 offenbart. Jedoch weisen die in diesen Polymeren enthaltenen Dihydrophenanthren-Einheiten nicht ausschliesslich Substituenten auf, die aus F, Alkyl, Alkenyl, Alkinyl, Aryl, Aralkyl, Aralkenyl, Aralkinyl und Heteroaryl ausgewählt sind.

In Frank Uckert: "Neue lösliche Poly(para-phenylen)-Derivate mit überbrückten Biphenyl-Untereinheiten - Synthese und Anwendung in blauen Leuchtdioden", Dissertation zur Erlangung des Grades 'Doktor der Naturwissenschaften' im Fachbereich Chemie und Pharmazie der Johannes Gutenberg-Universität in Mainz, 1998, Seiten 1-210, werden ausschliesslich Homopolymere mit Dihydrophenanthren-Einheiten offenbart.

Die oben beschriebenen Systeme weisen jedoch Mängel in Bezug auf die folgenden Parameter bzw. Eigenschaften auf:
■ Die Lebensdauer der blau emittierenden Polymere ist bei weitem noch nicht ausreichend für eine Verwendung in Massenprodukten.
■ Die Effizienz der nach dem Stand der Technik hergestellten Polymere ist zu niedrig.
■ Die Betriebsspannungen sind für die in Frage kommenden Anwendungen zu hoch.
■ Die Materialien erleiden häufig während des Betriebes eine Verschiebung der Emissionscharakteristik.
■ Die Materialien sind im Herstellungsprozess für OLEDs oft nur schwer prozessierbar, und führen beispielsweise bei Verarbeitung in Lösung (z.B. Inkjet-printing) zu einer Erhöhung der Viskosität.

Es wurde nun überraschend gefunden, dass Polymere enthaltend Dihydrophenanthreneinheiten gemäß der vorliegenden Erfindung eine deutlich bessere Farbstabilität, sowie eine deutlich verbesserte Elektronenstabilität und dadurch bedingt einen niedrigeren Betriebsspannungsanstieg zeigen. Dadurch kann die Lebensdauer der Polymere in PLEDs deutlich gesteigert werden.

Gegenstand der Erfindung sind somit konjugierte Polymere, die dadurch gekennzeichnet sind, dass sie eine oder mehrere Einheiten gemäß Formel (1) 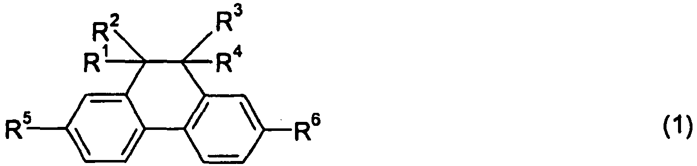 worin
- R¹⁻⁴: bei jedem Auftreten gleich oder verschieden F oder eine geradkettige, verzweigte oder cyclische Alkyl-, Alkenyl- oder Alkinylgruppe, oder eine Aryl-, Aralkyl-, Aralkenyl-, Aralkinyl- oder Heteroarylgruppe bedeuten, welche auch ein- oder mehrfach substituiert sein kann,
- R^{5,6}: eine Verknüpfung im Polymer bedeuten,
sowie weitere Struktureinheiten enthalten.

Die Verknüpfung der Einheiten der Formel (1) zu benachbarten Einheiten in den erfindungsgemäßen Polymeren kann entlang der Polymerhauptkette oder auch in der Polymerseitenkette erfolgen.

Vorzugsweise sind drei, besonders bevorzugt alle vier Reste R¹⁻⁴ von H verschieden.

Besonders bevorzugte Reste R¹⁻⁴ sind geradkettiges, verzweigtes oder cyclisches Alkyl, Alkenyl oder Alkinyl mit 1 bis 40, vorzugsweise 1 bis 25, besonders bevorzugt 1 bis 18 C-Atomen, gegebenenfalls substituiertes Aryl mit 5 bis 40, vorzugsweise 5 bis 25 C-Atomen, oder gegebenenfalls substituiertes Alkylaryl, Arylalkyl mit 5 bis 40, vorzugsweise 5 bis 25 C-Atomen.

Ganz besonders bevorzugte Kohlenstoff- und Kohlenwasserstoffreste sind C₁-C₄₀ Alkyl, C₂-C₄₀ Alkenyl, C₂-C₄₀ Alkinyl, C₃-C₄₀ Allyl, C₄-C₄₀ Alkyldienyl, C₄-C₄₀ Polyenyl, C₆-C₄₀ Aryl, C₆-C₄₀ Alkylaryl, C₆-C₄₀ Arylalkyl, C₆-C₄₀ Heteroaryl, C₃-C₄₀ Cycloalkyl und C₃-C₄₀ Cycloalkenyl. Besonders bevorzugt sind C₁-C₂₂ Alkyl, C₂-C₂₂ Alkenyl, C₂-C₂₂ Alkinyl, C₃-C₂₂ Allyl, C₄-C₂₂ Alkyldienyl, C₆-C₁₂ Aryl, C₆-C₂₀ Arylalkyl und C₆-C₂₀ Heteroaryl.

Bevorzugte Alkylgruppen sind beispielsweise Methyl, Ethyl, n-Propyl, Isopropyl, Cyclopropyl, n-Butyl, Isobutyl, s-Butyl, t-Butyl, 2-Methylbutyl, Cyclobutyl, n-Pentyl, s-Pentyl, Cyclopentyl, n-Hexyl, Cyclohexyl, 2-Ethylhexyl, n-Heptyl, Cycloheptyl, 1,1,5-Trimethylheptyl, n-Octyl, Cyclooctyl, Dodecanyl, Trifluoromethyl, Perfluoro-n-butyl, 2,2,2-Trifluoroethyl, Perfluorooctyl und Perfluorohexyl.

Bevorzugte Alkenylgruppen sind beispielsweise Ethenyl, Propenyl, Butenyl, Pentenyl, Cyclopentenyl, Hexenyl, Cyclohexenyl, Heptenyl, Cycloheptenyl, Octenyl und Cyclooctenyl.

Bevorzugte Alkinylgruppen sind beispielsweise Ethinyl, Propinyl, Butinyl, Pentinyl, Hexinyl und Octinyl.

Arylgruppen können monocyclisch oder polycyclisch sein, d.h. sie können einen Ring (beispielsweise Phenyl) oder zwei oder mehr Ringe aufweisen, welche auch kondensiert (beispielsweise Naphthyl) oder kovalent verknüpft sein können (beispielsweise Biphenyl), oder eine Kombination von kondensierten und verknüpften Ringen beinhalten. Bevorzugt sind vollständig konjugierte Arylgruppen.

Bevorzugte Arylgruppen sind beispielsweise Phenyl, Biphenyl, Triphenyl, [1,1':3',1"]Terphenyl-2'-yl, Naphthyl, Anthracen, Binaphthyl, Phenanthren, Pyren, Dihydropyren, Chrysen, Perylen, Tetracen, Pentacen, Benzpyren, Fluoren, Inden, Indenofluoren und Spirobifluoren.

Bevorzugte Heteroarylgruppen sind beispielsweise 5-gliedrige Ringe wie Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol und 1,3,4-Thiadiazol, 6-gliedrige Ringe wie Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin und 1,2,3,5-Tetrazin, oder kondensierte Gruppen wie Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol. Anthroxazol, Phenanthroxazol, Isoxazol, Senzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen, Benzothiadiazothiophen oder Kombinationen dieser Gruppen. Die Heteroarylgruppen können auch mit Alkyl, Alkoxy, Thioalkyl, Fluor, Fluoralkyl oder weiteren Aryl- oder Heteroarylgruppen substituiert sein.

Die Begriffe "Alkyl", "Aryl", "Heteroaryl" etc. umfassen auch mehrbindige Gruppen, beispielsweise Alkylen, Arylen, Heteroarylen etc.

"Halogen" bedeutet F, Cl, Br oder I.

"Konjugierte Polymere" im Sinne dieser Erfindung sind Polymere, die in der Hauptkette hauptsächlich sp²-hybridisierte (bzw. gegebenenfalls auch sp-hybridisierte) Kohlenstoffatome, die auch durch entsprechende Heteroatome ersetzt sein können, enthalten. Dies bedeutet im einfachsten Fall abwechselndes Vorliegen von Doppel- und Einfachbindungen in der Hauptkette, aber auch Polymere mit Einheiten wie beispielsweise metaverknüpftes Phenylen sollen im Sinne dieser Erfindung als konjugierte Polymere gelten. "Hauptsächlich" meint, dass natürlich (unwillkürlich) auftretende Defekte, die zu Konjugationsunterbrechungen führen, den Begriff "konjugiertes Polymer" nicht entwerten. Des Weiteren wird in diesem Anmeldungstext ebenfalls als "konjugiert" bezeichnet, wenn sich in der Hauptkette beispielsweise Arylamineinheiten, Arylphosphineinheiten, Arylphosphinoxideinheiten und/oder bestimmte Heterocyclen (d.h. Konjugation über N-, O-, P- oder S-Atome) und/oder metallorganische Komplexe (d.h. Konjugation über das Metallatom) befinden. Analoges gilt für konjugierte Dendrimere.

Die Einheiten gemäß Formel (1) können erfindungsgemäß in die Haupt- oder in die Seitenkette des Polymers eingebaut werden. Bei Einbau in die Seitenkette besteht die Möglichkeit, dass die Einheit gemäß Formel (1) in Konjugation mit der Polymerhauptkette steht oder dass sie nichtkonjugiert zur Polymerhauptkette ist.

In einer bevorzugten Ausführungsform der Erfindung steht die Einheit gemäß Formel (1) in Konjugation mit der Polymerhauptkette. Dies kann einerseits dadurch erreicht werden, dass diese Einheit in die Hauptkette des Polymers so eingebaut wird, dass dadurch die Konjugation des Polymers, wie oben beschrieben, erhalten bleibt. Andererseits kann diese Einheit auch in die Seitenkette des Polymers so verknüpft werden, dass eine Konjugation zur Hauptkette des Polymers besteht. Dies ist beispielsweise der Fall, wenn die Verknüpfung mit der Hauptkette nur über sp²-hybridisierte (bzw. gegebenenfalls auch über sp-hybridisierte) Kohlenstoffatome, die auch durch entsprechende Heteroatome ersetzt sein können, erfolgt. Erfolgt die Verknüpfung jedoch durch Einheiten, wie beispielsweise einfache (Thio)Etherbrücken, Ester, Amide oder Alkylenketten, so ist die Struktureinheit gemäß Formel (1) als nichtkonjugiert zur Hauptkette definiert.

Die Anknüpfung der Einheiten der Formel (1) an die Hauptkette kann direkt oder über eine oder mehrere zusätzliche Einheiten erfolgen. Bevorzugte Einheiten zur Verknüpfung sind optional substituierte, geradkettige, verzweigte oder cyclische Alkylengruppen, Alkenylengrupen oder Alkinylengruppen, insbesondere optional substituierte C=C-Doppelbindungen, C≡C-Dreifachbindungen oder aromatische Einheiten, weitere zu Formel (1) identische oder verschiedene Di- und Triarylaminoeinheiten, Arylenvinyleneinheiten oder Arylenethinyleneinheiten. Bevorzugt ist eine Verknüpfung in Konjugation zur Hauptkette.

Die Reste R¹⁻⁴ in Formel (1) sind vorzugsweise ausgewählt aus den oben genannten Gruppen.

Besonders bevorzugt sind Struktureinheiten ausgewählt aus den folgenden Unterformeln: 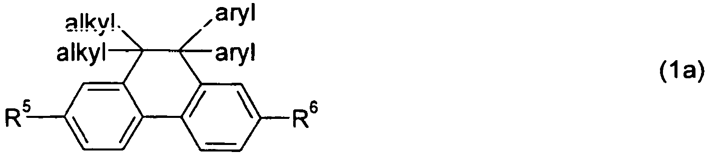 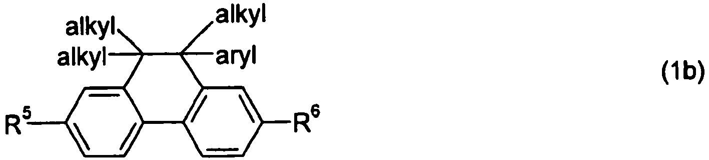 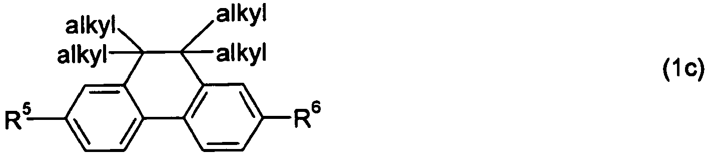 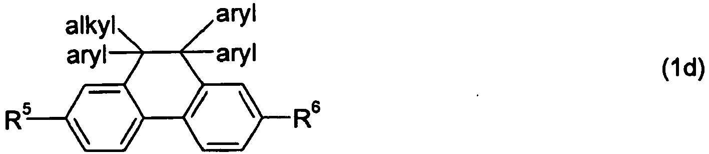 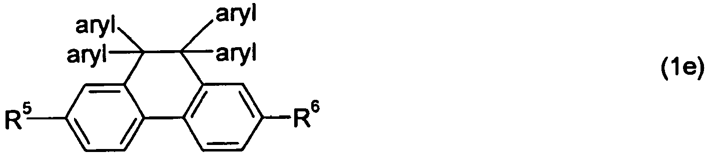 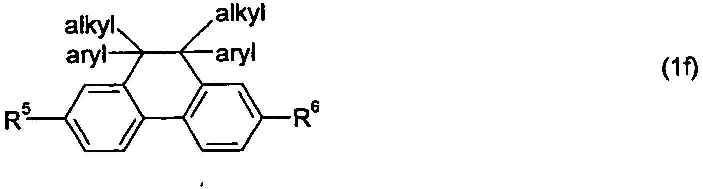 worin R¹, R², R⁵ und R⁶ die in Formel (1) angegebene Bedeutung besitzen, "alkyl" bei jedem Auftreten gleich oder verschieden einen geradkettigen, verzweigten oder cyclischen Alkylrest mit 1 bis 20 C-Atomen, "aryl" bei jedem Auftreten gleich oder verschieden einen optional substituierten Arylrest mit 5 bis 20 C-Atomen oder Heteroarylrest mit 3 bis 20 C-Atomen bedeutet.

Die Struktureinheiten der Formel (1) sind gut und in hohen Ausbeuten zugänglich.

Die erfindungsgemäßen konjugierten Polymere enthalten vorzugsweise mindestens 1 mol%, besonders bevorzugt 10 bis 99 mol% einer oder mehrerer Einheiten der Formel (1).

Besonders bevorzugt sind erfindungsgemäße Polymere, die neben Einheiten gemäß Formel (1) noch weitere Strukturelemente enthalten und somit als Copolymere zu bezeichnen sind. Die weiteren Struktureinheiten sind zwar notwendig zur Synthese der erfindungsgemäßen Copolymere, sie sind allerdings nicht selbst Gegenstand der vorliegenden Erfindung und sind somit durch Zitat zu beschreiben. Hier sei vor allem auch auf die relativ umfangreichen Auflistungen in der WO 02/077060, der WO 2005/014689 und die in diesen Schriften aufgeführten Zitate verwiesen. Diese weiteren Struktureinheiten können beispielsweise aus den im Folgenden beschriebenen Klassen stammen:
- Gruppe 1:: Struktureinheiten, welche das Polymer-Grundgerüst darstellen.
- Gruppe 2:: Struktureinheiten, welche die Lochinjektions- und/oder -transporteigenschaften der Polymere erhöhen.
- Gruppe 3:: Struktureinheiten, welche die Elektroneninjektions- und/oder -transporteigenschaften der Polymere deutlich erhöhen.
- Gruppe 4:: Struktureinheiten, die Kombinationen von Einzeleinheiten der Gruppe 2 und Gruppe 3 aufweisen.
- Gruppe 5:: Struktureinheiten, welche die Morphologie und/oder die Emissionsfarbe der resultierenden Polymere beeinflussen.
- Gruppe 6:: Struktureinheiten, welche die Emissionscharakteristik insoweit verändern, dass Elektrophosphoreszenz statt Elektrofluoreszenz erhalten werden kann.
- Gruppe 7:: Struktureinheiten, welche den Übergang vom Singulett- zum Triplettzustand verbessern.

Geeignete und bevorzugte Einheiten für die oben genannten Gruppen werden im Folgenden beschrieben.

Gruppe 1 - Struktureinheiten, welche das Polymer-Grundgerüst darstellen: Bevorzugte Einheiten der Gruppe 1 sind neben den Einheiten der Formel (1) insbesondere solche, die aromatische oder carbocyclische Strukturen mit 6 bis 40 C-Atomen beinhalten. Geeignete und bevorzugte Einheiten sind unter anderem Fluoren-Derivate, wie z.B. in der EP 0842208, der WO 99/54385, der WO 00/22027, der WO 00/22026 und der WO 00/46321 offenbart, Indenofluorene, ferner Spirobifluoren-Derivate, wie z.B. in der EP 0707020, der EP 0894107 und der WO 03/020790 offenbart, oder Dihydrophenanthren-Derivate, wie z.B. in der WO 2005/014689 offenbart. Es ist auch möglich, eine Kombination von zwei oder mehr dieser Monomer-Einheiten zu verwenden, wie z.B. in der WO 02/077060 beschrieben. Bevorzugte Einheiten für das Polymergrundgerüst sind neben den Einheiten der Formel (1) insbesondere Spirobifluorene und Indenofluorene.

Besonders bevorzugte Einheiten der Gruppe 1 sind zweibindige Einheiten gemäß den folgenden Formeln, worin die gestrichelte Linie die Verknüpfung zur benachbarten Einheit bedeutet: 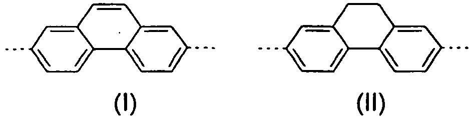 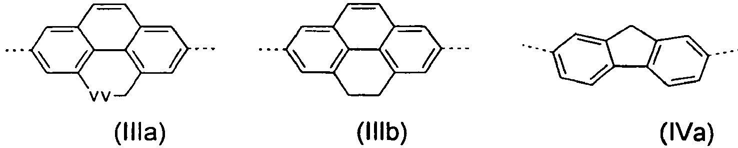 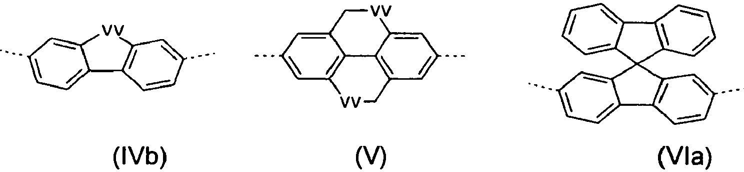 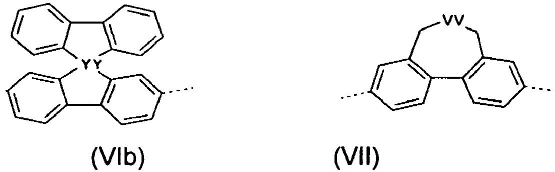 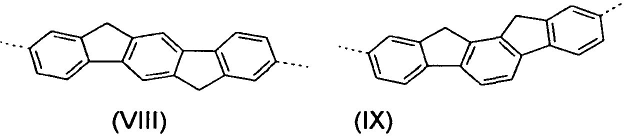 worin die einzelnen Reste folgende Bedeutung besitzen:
- YY: ist Si oder Ge,
- W: ist O, S oder Se.
und wobei die verschiedenen Formeln an den freien Positionen auch zusätzlich durch einen oder mehrere Substituenten R¹¹ substituiert sein können und R¹¹ folgendes bedeuten:
- R¹¹: ist bei jedem Auftreten gleich oder verschieden H, eine geradkettige, verzweigte oder cyclische Alkyl- oder Alkoxykette mit 1 bis 22 C-Atomen, in der auch ein oder mehrere nicht benachbarte C-Atome durch O, S, CO-O oder O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹² substituiert sein können, oder F, CN, N(R¹²)₂ oder B(R¹²)₂; und
- R¹²: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, CO-O oder O-CO-O ersetzt sein können, wobei auch ein oder mehrere H-Atome durch Fluor ersetzt sein können, oder eine optional substituierte Arylgruppe mit 5 bis 40 C-Atomen, bei der auch ein oder mehrere C-Atome durch O, S oder N ersetzt sein können.

Gruppe 2 - Struktureinheiten, welche die Lochinjektions- und/oder -transporteigenschaften der Polymere erhöhen:
Dies sind im Allgemeinen aromatische Amine oder elektronenreiche Heterocyclen, wie z.B. substituierte oder unsubstituierte Triarylamine, Benzidine, Tetraarylen-para-phenylendiamine, Phenothiazine, Phenoxazine, Dihydrophenazine, Thianthrene, Dibenzo-p-dioxine, Phenoxathiine, Carbazole, Azulene, Thiophene, Pyrrole, Furane und weitere O, S oder N-haltige Heterocyclen mit hoch liegendem HOMO (HOMO = höchst liegendes besetztes Molekülorbital). Es kommen hier aber auch Triarylphosphine in Frage, wie z.B. in der WO 2005/017065 A1 beschrieben.

Besonders bevorzugte Einheiten der Gruppe 2 sind zweibindige Einheiten gemäß den folgenden Formeln, worin die gestrichelte Linie die Verknüpfung zur benachbarten Einheit bedeutet: 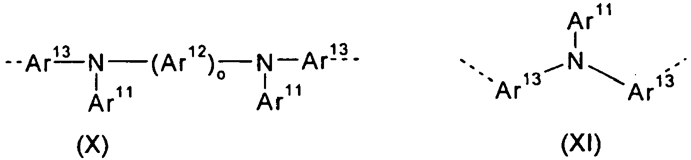 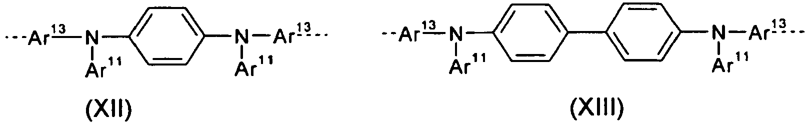 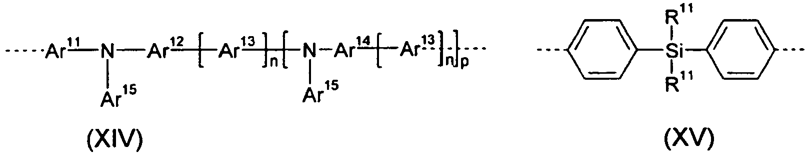 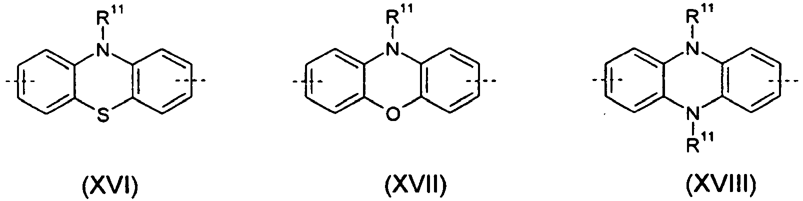 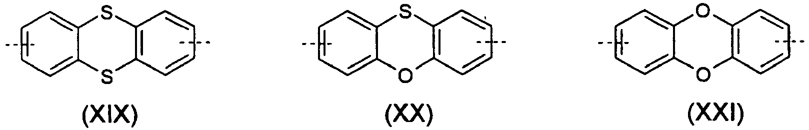 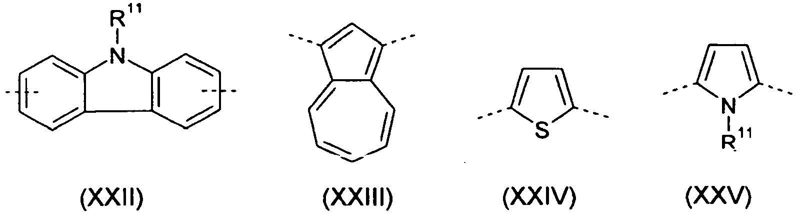 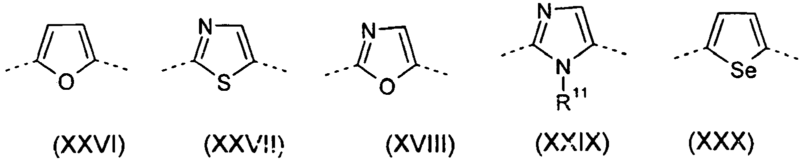 wobei R¹¹ eine der oben angegebenen Bedeutungen besitzt, die verschiedenen Formeln an den freien Positionen auch zusätzlich durch einen oder mehrere Substituenten R¹¹ substituiert sein können und die Symbole und Indices folgendes bedeuten:
- n: ist gleich oder verschieden bei jedem Auftreten 0, 1 oder 2,
- p: ist gleich oder verschieden bei jedem Auftreten 0, 1 oder 2, vorzugsweise 0 oder 1,
- o: ist gleich oder verschieden bei jedem Auftreten 1, 2 oder 3, vorzugsweise 1 oder 2,
- Ar¹¹, Ar¹³: sind bei jedem Auftreten gleich oder verschieden ein aromatisches oder heteroaromatisches Ringsystem mit 2 bis 40 C-Atomen, welches durch R¹¹ ein- oder mehrfach substituiert oder auch unsubstituiert sein kann; die möglichen Substituenten R¹¹ können dabei potentiell an jeder freien Position sitzen,
- Ar¹², Ar¹⁴: sind bei jedem Auftreten gleich oder verschieden Ar¹¹, Ar¹³ oder eine substituierte oder unsubstituierte Stilbenylen- bzw. Tolanyleneinheit,
- Ar¹⁵: ist gleich oder verschieden bei jedem Auftreten entweder ein System gemäß Ar¹¹ oder ein aromatisches oder heteroaromatisches Ringsystem mit 9 bis 40 aromatischen Atomen (C- oder Heteroatome), welches durch R¹¹ ein- oder mehrfach substituiert oder unsubstituiert sein kann und welches aus mindestens zwei kondensierten Ringen besteht; die möglichen Substituenten R¹¹ können dabei potentiell an jeder freien Position sitzen.

Gruppe 3 - Struktureinheiten, welche die Elektroneninjektions- und/oder -transporteigenschaften der Polymere deutlich erhöhen:
Dies sind im Allgemeinen elektronenarme Aromaten oder Heterocyclen, wie z.B. substituierte oder unsubstituierte Pyridine, Pyrimidine, Pyridazine, Pyrazine, Anthracene, Oxadiazole, Chinoline, Chinoxaline, Phenazine, Ketone, Phosphanoxide, Sulfoxide oder Triazine, aber auch Verbindungen wie Triarylborane und weitere O, S oder N-haltige Heterocyclen mit niedrig liegendem LUMO (LUMO = niedrigstes unbesetztes Molekülorbital), sowie Benzophenone und deren Derivate, wie z.B. in der WO 05/040302 offenbart.

Besonders bevorzugte Einheiten der Gruppe 3 sind zweibindige Einheiten gemäß den folgenden Formeln, worin die gestrichelte Linie die Verknüpfung zur benachbarten Einheit bedeutet: 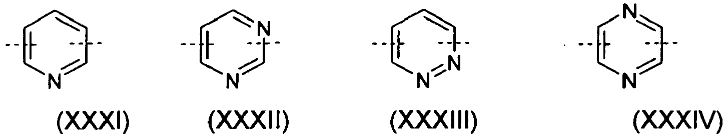 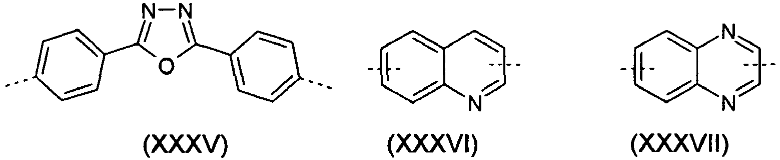 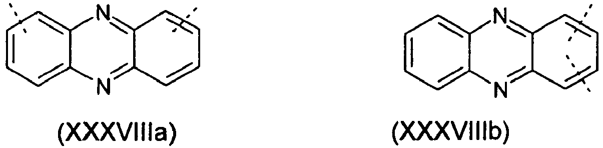 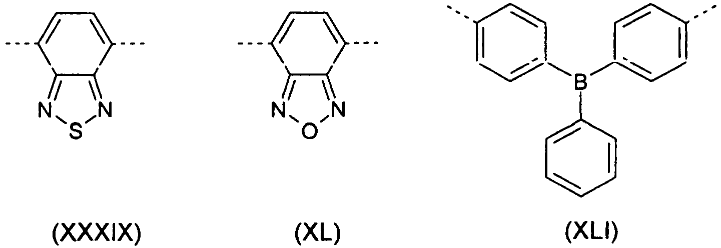 wobei die verschiedenen Formeln an den freien Positionen durch einen oder mehrere Substituenten R¹¹ wie oben definiert substituiert sein können.

Gruppe 4 - Struktureinheiten, die Kombinationen von Einzeleinheiten der Gruppe 2 und Gruppe 3 aufweisen:
Es ist auch möglich, dass die erfindungsgemäßen Polymere Einheiten enthalten, in denen Strukturen, welche die Lochmobilität und welche die Elektronenmobilität erhöhen, direkt aneinander gebunden sind. Allerdings verschieben einige dieser Einheiten die Emissionsfarbe ins Gelbe oder Rote. Ihre Verwendung in den erfindungsgemäßen Polymeren zur Erzeugung blauer oder grüner Emission ist deshalb weniger bevorzugt.

Falls solche Einheiten der Gruppe 4 in den erfindungsgemäßen Polymeren enthalten sind, sind sie vorzugsweise ausgewählt aus zweibindigen Einheiten gemäß den folgenden Formeln, worin die gestrichelte Linie die Verknüpfung zur benachbarten Einheit bedeutet: 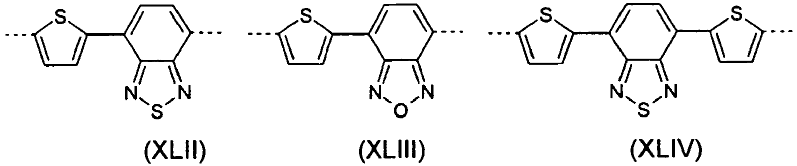 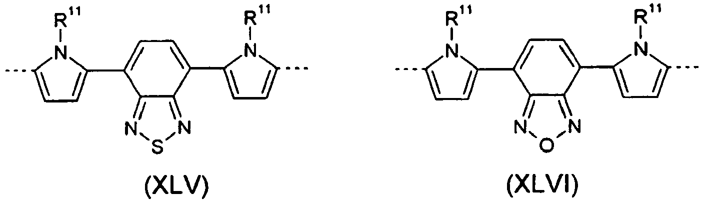 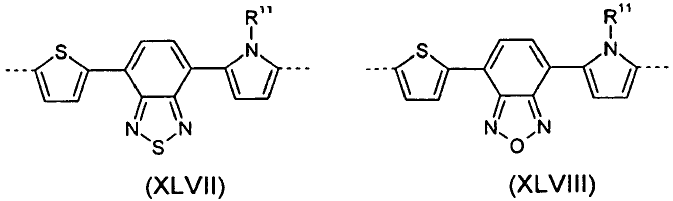 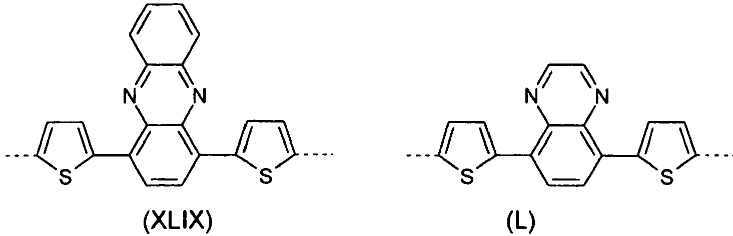 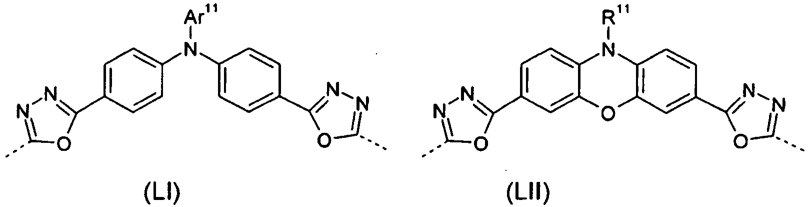 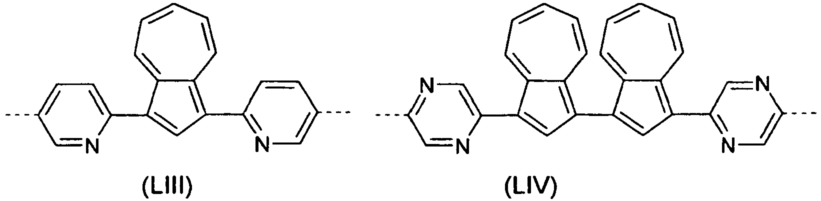 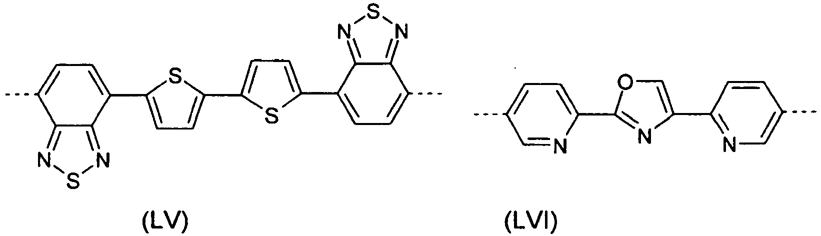 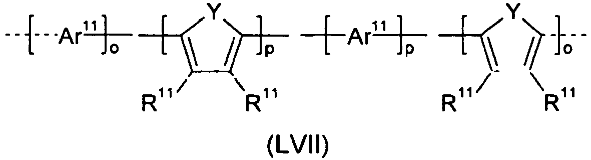 wobei die verschiedenen Formeln an den freien Positionen durch einen oder mehrere Substituenten R¹¹ substituiert sein können, die Symbole R¹¹, Ar¹¹, p und o die oben genannte Bedeutung besitzen und Y bei jedem Auftreten gleich oder verschieden O, S, Se, N, P, Si oder Ge ist.

Gruppe 5 - Struktureinheiten, welche die Morphologie und/oder die Emissionsfarbe der resultierenden Polymere beeinflussen:
Dies sind neben den oben genannten Einheiten solche, die mindestens noch eine weitere aromatische oder eine andere konjugierte Struktur aufweisen, welche nicht unter die o.g. Gruppen fällt, d.h. die die Ladungsträgermobilität nur wenig beeinflusst, die keine metallorganischen Komplexe sind oder die keinen Einfluss auf den Singulett-Triplett-Übergang haben. Derartige Strukturelemente können die Morphologie, aber auch die Emissionsfarbe der resultierenden Polymere beeinflussen. Je nach Einheit können sie daher auch als Emitter eingesetzt werden. Bevorzugt sind dabei substituierte oder unsubstituierte aromatische Strukturen mit 6 bis 40 C-Atomen oder auch Tolan-, Stilben- oder Bisstyrylarylenderivate, die jeweils mit einem oder mehreren Resten R¹¹ substituiert sein können. Besonders bevorzugt ist dabei der Einbau von 1,4-Phenylen-, 1,4-Naphthylen-, 1,4- oder 9,10-Anthrylen-, 1,6- oder 2,7- oder 4,9-Pyrenylen-, 3,9- oder 3,10- Perylenylen-, 4,4'-Biphenylylen-, 4,4"-Terphenylylen-, 4,4'-Bi-1,1'-naphthylylen-, 4,4'-Tolanylen-, 4,4'-Stilbenylen- oder 4,4"-Bisstyrylarylenderivaten.

Ganz besonders bevorzugt sind substituierte oder unsubstituierte Strukturen gemäß den folgenden Formeln: 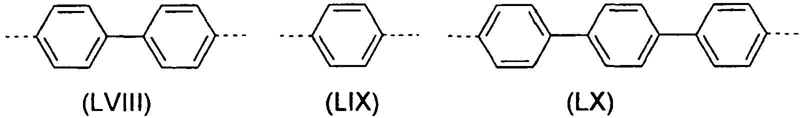 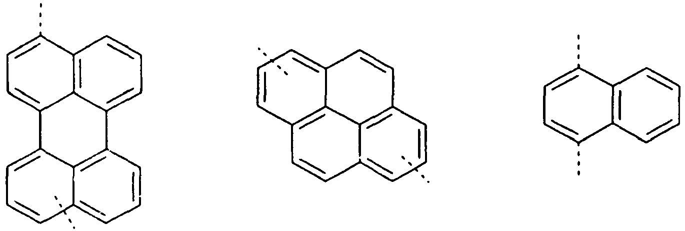 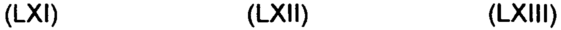 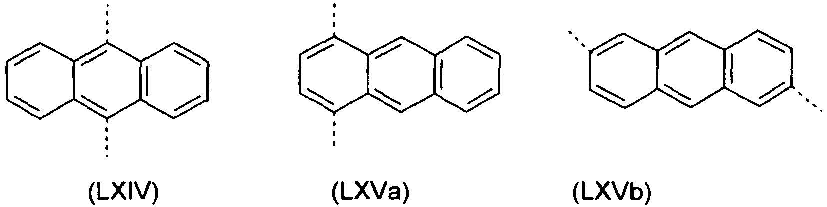 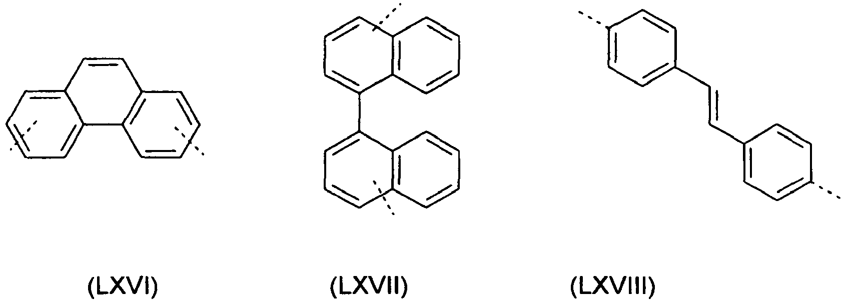 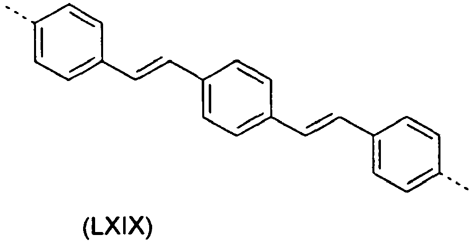 wobei die verschiedenen Formeln an den freien Positionen durch einen oder mehrere Substituenten R¹¹ wie oben definiert substituiert sein können.

Gruppe 6 - Struktureinheiten, welche die Emissionscharakteristik insoweit verändern, dass Elektrophosphoreszenz statt Elektrofluoreszenz erhalten werden kann:
Dies sind insbesondere solche Einheiten, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Besonders geeignet sind Verbindungen, welche d- oder f-Übergangsmetalle beinhalten, die die o.g. Bedingung erfüllen. Ganz besonders bevorzugt sind hier entsprechende Struktureinheiten, welche Elemente der Gruppe 8 bis 10 (Ru, Os, Rh, Ir, Pd, Pt) enthalten. Als Struktureinheiten für die erfindungsgemäßen Polymeren kommen hier z.B. verschiedene Komplexe in Frage, welche z.B. in der WO 02/068435, der WO 02/081488, der EP 1239526 und der WO 04/026886 beschrieben sind. Entsprechende Monomere sind in der WO 02/068435 und der WO 2005/042548 A1 beschrieben.

Bevorzugte Einheiten der Gruppe 6 sind solche der folgenden Formeln: 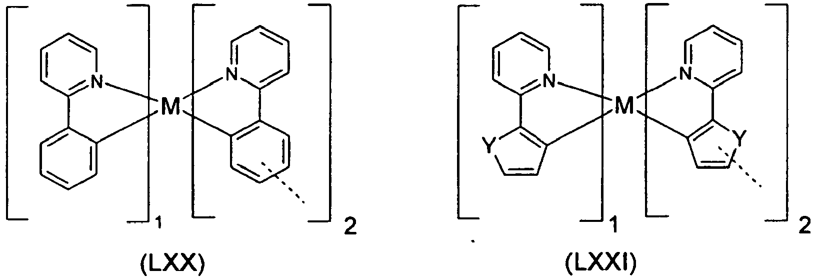 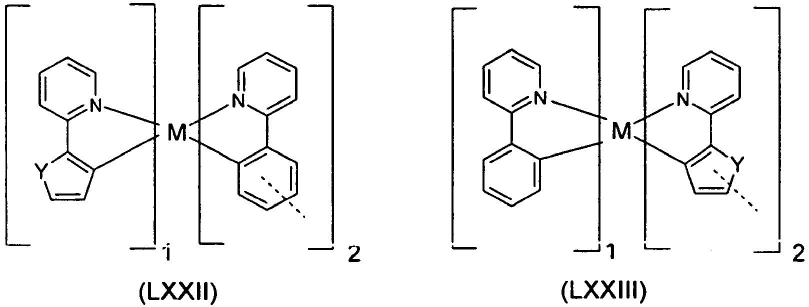 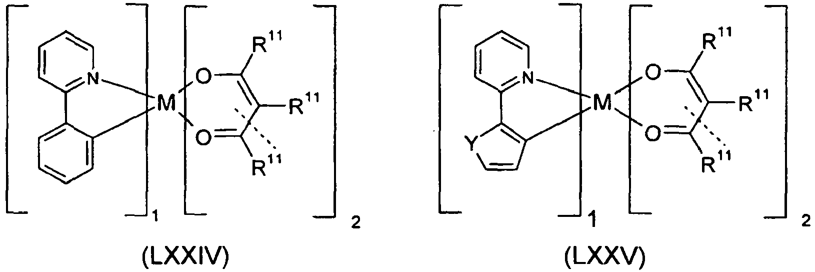 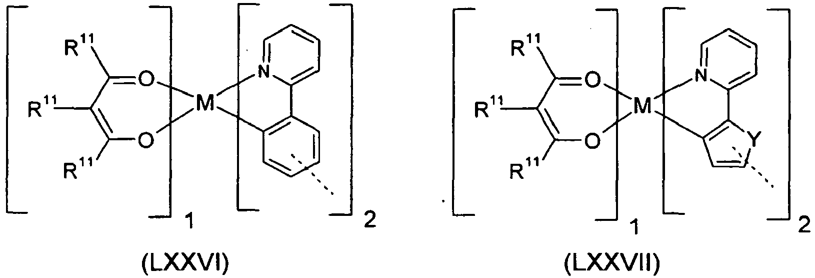 worin M für Rh oder Ir steht, Y die oben angegebene Bedeutung hat, und die verschiedenen Formeln an den freien Positionen durch eine oder mehrere Substituenten R¹¹ wie oben definiert substituiert sein können.

Gruppe 7 - Struktureinheiten, welche den Übergang vom Singulett- zum Triplettzustand verbessern:
Dies sind insbesondere solche Einheiten, welche den Übergang vom Singulett- zum Triplettzustand verbessern und welche, unterstützend zu den Strukturelementen der Gruppe 6 eingesetzt, die Phosphoreszenzeigenschaften dieser Strukturelemente verbessern. Hierfür kommen insbesondere Carbazol- und überbrückte Carbazoldimereinheiten in Frage, wie z.B. in der WO 04/070772 und der WO 04/113468 beschrieben. Weiterhin kommen hierfür Ketone, Phosphinoxide, Sulfoxide und ähnliche Verbindungen in Frage, wie z.B. in der WO 2005/040302 A1 beschrieben.

Es ist auch möglich, dass gleichzeitig mehr als eine Struktureinheit aus einer der Gruppen 1 bis 7 vorliegt.

Das erfindungsgemäße Polymer kann weiterhin ebenfalls in die Haupt- oder Seitenkette gebundene Metallkomplexe enthalten, die im Allgemeinen aus einem oder mehreren Liganden und einem oder mehreren Metallzentren aufgebaut sind.

Bevorzugt sind erfindungsgemäße Polymere, die gleichzeitig neben Struktureinheiten gemäß Formel (1) zusätzlich noch ein oder mehrere Einheiten ausgewählt aus den Gruppen 1 bis 7 enthalten.

Bevorzugt sind dabei erfindungsgemäße Polymere, die neben Einheiten gemäß Formel (1) noch Einheiten aus der Gruppe 1 enthalten, besonders bevorzugt mindestens 1 mol% dieser Einheiten.

Ebenfalls bevorzugt ist es, wenn die erfindungsgemäßen Polymere Einheiten enthalten, die den Ladungstransport oder die Ladungsinjektion verbessern, also Einheiten aus Gruppe 2 und/oder 3; besonders bevorzugt ist ein Anteil von 1 bis 30 mol% dieser Einheiten; ganz besonders bevorzugt ist ein Anteil von 2 bis 10 mol% dieser Einheiten.

Besonders bevorzugt ist es weiterhin, wenn die erfindungsgemäßen Polymere Einheiten aus Gruppe 1, Einheiten aus Gruppe 2 und/oder 3 und Einheiten aus Gruppe 5 enthalten.

Bevorzugt beträgt der Anteil der Einheiten gemäß Formel (1) mindestens 10 mol%, besonders bevorzugt mindestens 30 mol%, insbesondere mindestens 50 mol%. Diese Bevorzugung gilt vor allem, wenn es sich bei den Einheiten gemäß Formel (1) um das Polymer-Grundgerüst handelt. Bei anderen Funktionen können andere Anteile bevorzugt sein, beispielsweise ein Anteil in der Größenordnung von 5 bis 20 mol%, wenn es sich um den Lochleiter bzw. den Emitter in einem elektrolumineszierenden Polymer handelt. Für andere Anwendungen, beispielsweise für organische Transistoren, kann der bevorzugte Anteil nochmals unterschiedlich sein, beispielsweise bis zu 100 mol%, wenn es sich um loch- oder elektronenleitende Einheiten handelt.

Die erfindungsgemäßen Polymere weisen vorzugsweise 10 bis 10000, besonders bevorzugt 20 bis 5000 und insbesondere 50 bis 2000 Wiederholeinheiten auf.

Die nötige Löslichkeit der Polymere wird vor allem durch die Substituenten an den verschiedenen Wederholeinheiten gewährleistet, sowohl den Substituenten R¹⁻⁴ an Einheiten gemäß Formel (1), wie auch durch Substituenten an den anderen Wiederholeinheiten.

Die erfindungsgemäßen Polymere sind entweder Homopolymere aus Einheiten gemäß Formel (1) oder Copolymere. Die erfindungsgemäßen Polymere können linear oder verzweigt (vernetzt) sein. Erfindungsgemäße Copolymere können dabei neben einer oder mehreren Strukturen gemäß Formel (1), oder deren bevorzugten Unterformeln, potentiell eine oder mehrere weitere Strukturen aus den oben aufgeführten Gruppen 1 bis 4 besitzen.

Die erfindungsgemäßen Copolymere können statistische, alternierende oder blockartige Strukturen aufweisen oder auch mehrere dieser Strukturen abwechselnd besitzen. Wie Copolymere mit blockartigen Strukturen erhalten werden können und welche weiteren Strukturelemente dafür besonders bevorzugt sind, ist beispielsweise ausführlich in der WO 2005/014688 beschrieben. Diese Schrift ist via Zitat Bestandteil der vorliegenden Anmeldung. Ebenso sei an dieser Stelle nochmals hervorgehoben, dass das Polymer auch dendritische Strukturen haben kann.

Die erfindungsgemäßen Polymere werden in der Regel durch Polymerisation von einer oder mehreren Monomersorten hergestellt, von denen mindestens ein Monomer durch die Formel (1) beschrieben ist. Geeignete Polymerisationsreaktionen sind dem Fachmann bekannt und in der Literatur beschrieben. Besonders geeignete und bevorzugte Polymerisations- und Kupplungsreaktionen, die alle zu C-C-Verknüpfungen führen, sind solche gemäß SUZUKI, YAMAMOTO, STILLE, HECK, NEGISHI, SONOGASHIRA oder HIYAMA.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 2003/048225 und der WO 2004/037887 im Detail beschrieben.

Die C-C-Verknüpfungen sind bevorzugt ausgewählt aus den Gruppen der SUZUKI-Kupplung, der YAMAMOTO-Kupplung und der STILLE-Kupplung.

Zur Synthese der Polymere werden die entsprechenden Monomere benötigt. Die Synthese von Einheiten aus Gruppe 1 bis 7 ist dem Fachmann bekannt und in der Literatur, beispielsweise in der WO 2005/014689, beschrieben. Diese und die darin zitierte Literatur ist via Zitat Bestandteil der vorliegenden Anmeldung.

Monomere, die in erfindungsgemäßen Polymeren und Dendrimeren zu Struktureinheiten gemäß Formel (1) führen, sind vorzugsweise ausgewählt aus Formel (1) 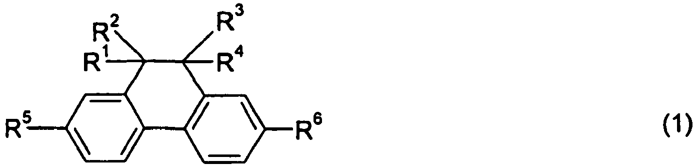 worin R¹⁻⁴ die oben angegebenen Bedeutungen besitzen, und R⁵ und R⁶ jeweils unabhängig voneinander eine reaktive Gruppe Z bedeuten, die für eine Polymerisationsreaktion geeignet ist.

Besonders bevorzugte Gruppen Z sind ausgewählt aus Halogen, insbesondere Cl, Br, I, O-Tosylat, O-Triflat, O-SO₂R', B(OH)₂, B(OR')₂ oder Sn(R')₃, ferner O-Mesylat, O-Nonaflat, SiMe₂F, SiMeF₂, CR'=C(R')₂, oder C≡CH, worin R' optional substituiertes Alkyl oder Aryl bedeutet und zwei Gruppen R' ein aromatisches oder aliphatisches, mono- oder polycyclisches Ringsystem bilden können. "Aryl" und "Alkyl" besitzen vorzugsweise eine der oben angegebenen Bedeutungen.

Ferner bevorzugt sind Monomere der oben gezeigten Unterformeln (1a)-(1g), worin R⁵ und R⁶ jeweils unabhängig voneinander Z bedeuten.

Die Monomere können durch Verfahren hergestellt werden, die dem Fachmann bekannt und in Standardwerken der organischen Chemie beschrieben sind. Besonders geeignete und bevorzugte Verfahren sind in den Beispielen beschrieben.

Die erfindungsgemäßen Polymere weisen gegenüber den Polymeren gemäß Stand der Technik folgende Vorteile auf:
(1) Die erfindungsgemäßen Polymere zeigen eine höhere Photostabilität im Vergleich zu Polymeren gemäß dem Stand der Technik. Dies ist von entscheidender Bedeutung für die Anwendung dieser Polymere, da sie sich weder durch die durch Elektrolumineszenz freigesetzte Strahlung, noch durch von außen einfallende Strahlung zersetzen dürfen. Diese Eigenschaft ist bei Polymeren gemäß dem Stand der Technik noch mangelhaft.
(2) Die erfindungsgemäßen Polymere weisen (bei ansonsten gleicher oder ähnlicher Zusammensetzung) vergleichbare oder höhere Leuchteffizienzen in der Anwendung auf. Dies ist von enormer Bedeutung, da somit entweder gleiche Helligkeit bei geringerem Energieverbrauch erzielt werden kann, was vor allem bei mobilen Applikationen (Displays für Handys, Pager, PDA etc.), die auf Batterien und Akkus angewiesen sind, sehr wichtig ist. Umgekehrt erhält man bei gleichem Energieverbrauch höhere Helligkeiten, was beispielsweise für Beleuchtungsanwendungen interessant sein kann.
(3) Des Weiteren hat sich überraschend gezeigt, dass, wiederum im direkten Vergleich, die erfindungsgemäßen Polymere vergleichbare oder höhere operative Lebensdauern aufweisen.
(4) Die erfindungsgemäßen Polymere und diese enthaltende Lösungen und Formulierungen besitzen eine verbesserte Prozessierbarkeit, insbesondere eine niedrigere Viskosität in Lösung.
(5) Die erfindungsgemäßen Polymere zeigen eine größere Farbstabilität, insbesondere bei dunkelblauen Farbkoordinaten.

Es kann außerdem bevorzugt sein, das erfindungsgemäße Polymer nicht als Reinsubstanz, sondern als Mischung (Blend) zusammen mit weiteren beliebigen polymeren, oligomeren, dendritischen oder niedermolekularen Substanzen zu verwenden. Diese können beispielsweise die elektronischen Eigenschaften verbessern oder selber emittieren. Solche Blends sind daher auch Bestandteil der vorliegenden Erfindung.

Gegenstand der Erfindung sind weiterhin Lösungen und Formulierungen aus einem oder mehreren erfindungsgemäßen Polymeren oder Blends in einem oder mehreren Lösungsmitteln. Wie Polymerlösungen hergestellt werden können, ist dem Fachmann bekannt und z.B. in der WO 02/072714, der WO 03/019694 und der darin zitierten Literatur beschrieben.

Diese Lösungen können verwendet werden, um dünne Polymerschichten herzustellen, zum Beispiel durch Flächenbeschichtungsverfahren (z. B. Spin-coating) oder durch Druckverfahren (z.B. InkJet Printing).

Die erfindungsgemäßen Polymere können in PLEDs verwendet werden. Wie PLEDs hergestellt werden können, ist dem Fachmann bekannt und wird z.B. als allgemeines Verfahren ausführlich in der WO 2004/070772 beschrieben, das entsprechend für den Einzelfall anzupassen ist.

Wie oben beschrieben, eignen sich die erfindungsgemäßen Polymere ganz besonders als Elektrolumineszenzmaterialien in derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Polymers oder Blends in einer PLED, insbesondere als Elektrolumineszenzmaterial.

Gegenstand der Erfindung ist somit ebenfalls eine PLED mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht und/oder eine Trsnspcrtschicht und/oder eine Ladungsinjektionnsschicht sein. Besonders bevorzugt ist die Verwendung der erfindungsgemäßen Polymere in PLEDs mit einem Interlayer.

Im vorliegenden Anmeldetext und auch in den im Weiteren folgenden Beispielen wird auf die Verwendung erfindungsgemäßer Polymere oder Blends in Bezug auf PLEDs und entsprechende Displays abgezielt. Trotz dieser Beschränkung der Beschreibung ist es für den Fachmann ohne weiteres erfinderisches Zutun möglich, die erfindungsgemäßen Polymere als Halbleiter auch für weitere Verwendungen in anderen elektronischen Devices (Vorrichtungen) zu benutzen, z.B. in organischen Feld-Effekt-Transistoren (OFETs), in organischen integrierten Schaltungen (O-ICs), in organischen Dünnfilmtransistoren (TFTs), in organischen Solarzellen (O-SCs), in organischen Laserdioden (O-Laser) oder in organischen photovoltaischen (OPV) Elementen oder Vorrichtungen, um nur einige Anwendungen zu nennen.

Die Verwendung der erfindungsgemäßen Polymere in den entsprechenden Vorrichtungen ist ebenfalls ein Gegenstand der vorliegenden Erfindung.

Die Verbindungen der Formel (1) können nach dem Fachmann bekannten und in der Literatur, wie z.B. in der WO 2005/014689, beschriebenen Methoden hergestellt werden. Weitere geeignete und bevorzugte Syntheseverfahren finden sich in den Beispielen.

Monomere der Formel (1) können beispielsweise hergestellt werden, indem man ein 2,7-Dihalophenanthren-9,10-dichinon mit einem Organomagnesiumhalogenid nach Grignard umsetzt, das entstehende 2,7-Dihalo-9,1 0-disubstituierte 9,10-Dihydrophenanthren-9,10-diol mit einer vorzugsweise starken Säure erhitzt und das dabei entstehende 2,7-Dihalo-10,10-disubstituierte 10-Hydrophenanthren-9-on mit einem metallorganischen Zinkreagenz umsetzt.

Die folgenden Beispiele sollen die Erfindung erläutern, ohne sie einzuschränken. Insbesondere sind die darin beschriebenen Merkmale, Eigenschaften und Vorteile der dem betreffenden Beispiel zugrunde liegenden definierten Verbindungen auch auf andere, nicht im Detail aufgeführte, aber unter den Schutzbereich der Ansprüche fallende Verbindungen anwendbar, sofern an anderer Stelle nichts Gegenteiliges gesagt wird.

### Beispiel 1: Synthese eines Monomers

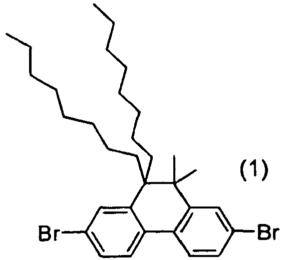

Monomer (1) wird hergestellt wie nachfolgend beschrieben.

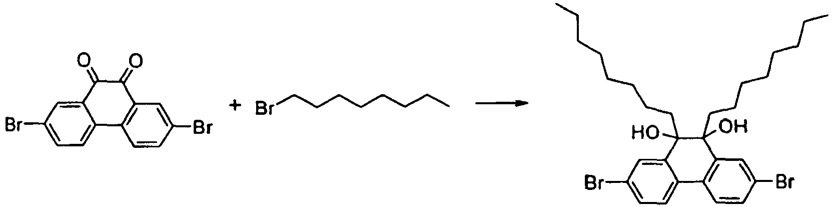

Es werden 50 g Mg vorgelegt, die Apparatur ausgeheizt und 358 ml Octylbromid in 700 ml trockenem THF gelöst zugetropft. Die Lösung wird so zugetropft, dass die Reaktion ohne zu heizen unter Rückfluss rührt. Nach beendeter Zugabe (nach ca. 40 Minuten), wird ein auf 85°C vorgeheiztes Ölbad untergestellt und weiter ca. 1,5 Stunden unter Rückfluss gekocht bis sich das Mg vollständig gelöst hat. Das Ölbad wird entfernt und 1,3 l trockenes THF zugegeben, auf RT abgekühlt und per Trichter und Ausguss unter Argon in den Tropftrichter einer zweiten ausgeheizten Apparatur überführt.

In der 2. Apparatur werden 253 g Dibromphenanthrenchinon in 1000 ml THF suspendiert. Die Suspension wird auf ca. 0°C abgekühlt und die Grignardlösung so zugetropft, dass die Innentemperatur 25°C nicht übersteigt, anschließend wird über Nacht bei Raumtemperatur gerührt. 320 ml Eisessig/H₂O 1:1 werden über 20 Minuten unter Eiskühlung zugetropft; diese Reaktion ist stark exotherm. Es wird eine weitere Stunde gerührt, dabei bilden sich zwei Phasen. Die Phasen werden getrennt und die organische Phase im Vakuum auf 0,5 l reduziert. Die organische Phase wird anschließend mit 1,5 l Essigester verdünnt und zweimal mit gesättigter NaCl extrahiert und über Na₂SO₄ getrocknet. Das Trockenmittel wird über einen Faltenfilter abfiltriert. Das Lösungsmittel wird im Vakuum abgezogen. Man erhält einen dunkelroten Feststoff. Das Rohprodukt wird aus 800 ml Heptan umkristallisiert. Als Produkt erhält man einen weißen Feststoff.

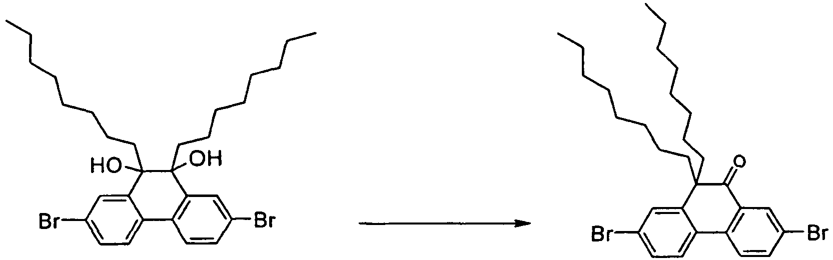

150 g Dioctyldihydroxy-DHP werden in 850 ml Eisessig und 450 ml Trifluoressigsäure suspendiert, und die Mischung zum Sieden erhitzt und unter Rückfluss gerührt. Bei ca. 60°C Innentemperatur ist die Reaktionsmischung eine klare gelbe Lösung. Nach ca. 2,5 Stunden Rückfluss fällt ein gelber Feststoff aus. Die Reaktion wird langsam auf Raumtemperatur abkühlt. Der Niederschlag wird abgesaugt und mit Essigsäure dann mit Wasser gewaschen. Der Feststoff wird in ca. 2 l Wasser und 1 l Methanol über Nacht bei Raumtemperatur ausgerührt. Der feine Niederschlag wird abgesaugt, mit Wasser und anschließend mit Methanol gewaschen.

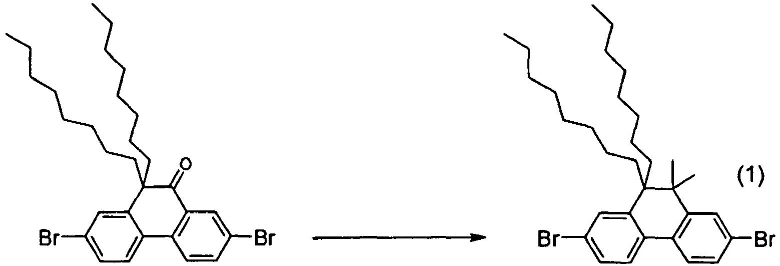

Die Apparatur wird unter Schutzgasstrom ausgeheizt und auf Raumtemperatur abgekühlt. 40 ml einer 1M Titantetrachlorid in Dichlormethan werden mit 63 ml wasserfreiem Dichlormethan verdünnt und im Isopropanol / Trockeneisbad auf -30 bis -40°C abkühlt. 40 ml 1 M Dimethylzinklösung in Heptan wird langsam zudosiert. Nach beendeter Zugabe wird noch 15 Minuten nachgerührt. 10 g des DHP-Ketons werden in 20 ml wasserfreiem Dichlormethan gelöst und zur Reaktionsmischung bei -30°C zugetropft. Die Reaktionsmischung wird über Nacht auf Raumtemperatur erwärmt. Die Reaktionsmischung wird vorsichtig auf Eiswasser geben. Die Phasen werden getrennt. Die organische Phase wird zweimal mit Wasser ausgeschüttelt, über Na₂SO₄ getrocknet, das Trockenmittel abfiltriert und das Lösungsmittel im Vakuum abgezogen. Das Rohprodukt wird über eine Kieselgel-Säule chromatografiert. Laufmittel: Heptan:Essigester 100:1.

### Beispiel 2: Synthese von Polymeren

Die Polymere P1 bis P3, die Monomere der untenstehenden Zusammensetzungen enthalten, werden durch SUZUKI-Kupplung gemäß der WO 03/048225 synthetisiert.

### Zusammensetzungder Polymere P1 bis P3:

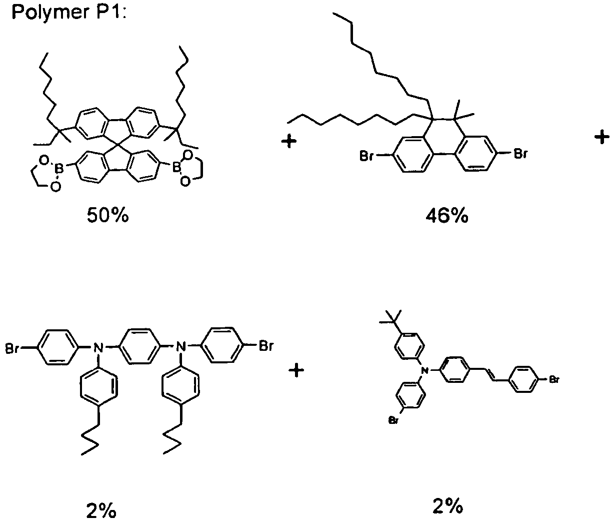

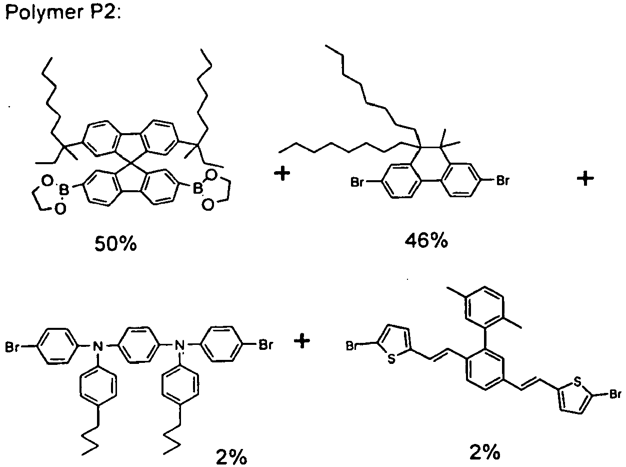

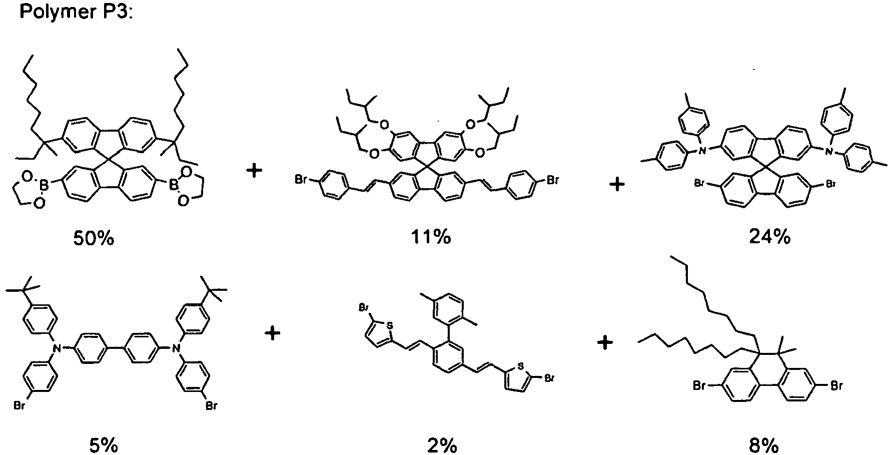

| Bsp. | Polymer | Max.Eff [Cd/A] | U@100cd/m² [V] | CIE [x/y] | Lebensdauer [h] |
|---|---|---|---|---|---|
| 1 | P1 | 5,50 | 5,11 | 0,15/0,71 | 194@1000 |
| 2 | P2 | 17,38 | 4,89 | 0,32/0,60 | 159@6000 |
| 3 | P3 | 8,34 | 4,00 | 0,39/0,40 | 427@2000 |

## Patentansprüche

1. Konjugierte Polymere, **dadurch gekennzeichnet, dass** sie eine oder mehrere Einheiten gemäß Formel (1) 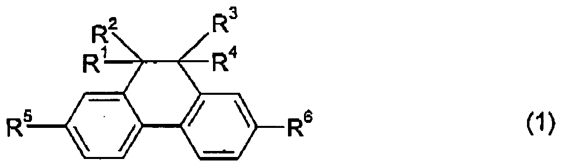 worin
R¹⁻⁴ bei jedem Auftreten gleich oder verschieden F oder eine geradkettige, verzweigte oder cyclische Alkyl-, Alkenyl- oder Alkinylgruppe, wobei auch ein oder mehrere H-Atome durch Fluor ersetzt sein können, oder eine Aryl-, Aralkyl-, Aralkenyl-, Aralkinyl- oder Heteroarylgruppe bedeuten, welche auch ein- oder mehrfach substituiert sein kann,
R^{5,6} eine Verknüpfung im Polymer bedeuten,
sowie weitere Struktureinheiten enthalten.

2. Polymere nach Anspruch 1, **dadurch gekennzeichnet, dass** die Einheiten gemäß Formel (1) in die Hauptkette des Polymers eingebaut sind.

3. Polymere nach Anspruch 1 oder 2, **dadurch gekennzeichnet, dass** die Reste R¹⁻⁴ ausgewählt sind aus der Gruppe enthaltend C₁-C₄₀ Alkyl, C₂-C₄₀ Alkenyl, C₂-C₄₀ Alkinyl, C₃-C₄₀ Allyl, C₄-C₄₀ Alkyldienyl, C₄-C₄₀ Polyenyl, C₆-C₄₀ Aryl, C₆-C₄₀ Alkylaryl, C₆-C₄₀ Arylalkyl, C₆-C₄₀ Heteroaryl, C₄-C₄₀ Cycloalkyl und C₄-C₄₀ Cycloalkenyl.

4. Polymere nach mindestens einem der Ansprüche 1 bis 3, **dadurch gekennzeichnet, dass** die Einheiten der Fomel (1) ausgewählt sind aus den folgenden Unterformeln 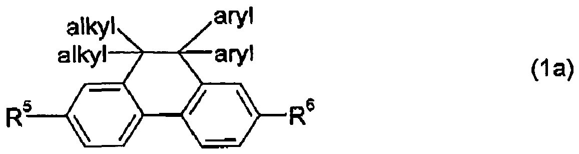 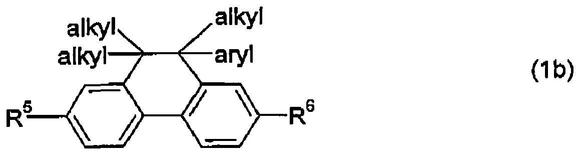 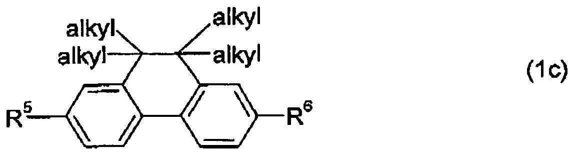 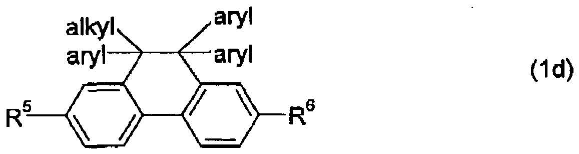 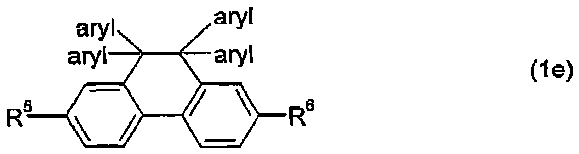 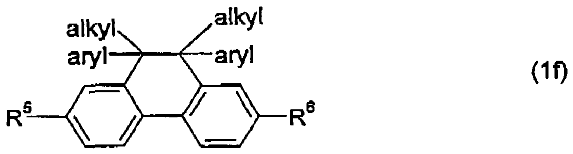 worin R¹, R², R⁵ und R⁶ die in Anspruch 1 angegebene Bedeutung besitzen,
"alkyl" bei jedem Auftreten gleich oder verschieden einen geradkettigen, verzweigten oder cyclischen Alkylrest mit 1 bis 20 C-Atomen bedeutet,
"aryl" bei jedem Auftreten gleich oder verschieden einen optional substituierten Arylrest mit 5 bis 20 C-Atomen oder Heteroarylrest mit 3 bis 20 C-Atomen bedeutet.

5. Polymere nach mindestens einem der Ansprüche 1 bis 4, **dadurch gekennzeichnet, dass** sie weitere Strukturelemente enthalten, ausgewählt aus den Gruppen der Fluorenylene, Spirobifluorenylene, Tetrahydropyrenylene, Stilbenylene, Bisstyrylarylene, 1,4-Phenylene, 1,4-Naphthylene, 1,4- oder 9,10-Anthrylene, 1,6- oder 2,7- oder 4,9-Pyrenylene, 3,9- oder 3,10-Perylenylene, 2,7- oder 3,6-Phenanthrenylene, 4,4'-Biphenylylene, 4,4"-Terphenylylene oder 4,4'-Bi-1,1'-naphthylylene.

6. Polymere nach mindestens einem der Ansprüche 1 bis 5, **dadurch gekennzeichnet, dass** sie weitere Strukturelemente enthalten, ausgewählt aus den Gruppen der Triarylamine, Triarylphosphine, Benzidine, Tetraarylen-para-phenylendiamine, Phenothiazine, Phenoxazine, Dihydrophenazine, Thianthrene, Dibenzo-p-dioxine, Phenoxathiine, Carbazole, Azufene, Thiophene, Pyrrole oder Furane.

7. Polymere nach mindestens einem der Ansprüche 1 bis 6, **dadurch gekennzeichnet, dass** sie weitere Strukturelemente enthalten, ausgewählt aus den Gruppen der Pyridine, Pyrimidine, Pyridazine, Pyrazine, Anthracene, Triarylborane, Oxadiazole, Chinoline, Chinoxaline, Phenazine, Ketone, Phosphanoxide, Sulfoxide oder Triazine.

8. Polymere nach mindestens einem der Ansprüche 1 bis 7, **dadurch gekennzeichnet, dass** der Anteil der Struktureinheiten gemäß Formel (1) 10 bis 99 mol% beträgt.

9. Blend eines oder mehrerer Polymere nach mindestens einem der Ansprüche 1 bis 8 mit einer oder mehreren weiteren polymeren, oligomeren, dendritischen oder niedermolekularen Substanzen.

10. Lösungen und Formulierungen enthaltend ein oder mehrere erfindungsgemäße Polymere oder Blends nach mindestens einem der Ansprüche 1 bis 9 in einem oder mehreren Lösungsmitteln.

11. Verwendung von Polymeren, Blends, Lösungen oder Formulierungen nach mindestens einem der Ansprüche 1 bis 10 in einem elektronischen Bauteil, vorzugsweise in einer organischen Leuchtdiode (OLED).

12. Elektronisches Bauteil enthaltend ein oder mehrere Polymere, Blends, Lösungen oder Formulierungen nach mindestens einem der Ansprüche 1 bis 10.

13. Elektronisches Bauteil nach Anspruch 12, **dadurch gekennzeichnet, dass** es sich um einen Feld-Effekt-Transistor (OFET), organischen Dünnfilmtransistor (O-TFT), organische integrierte Schaltung (O-IC), organische Solarzelle (O-SCs), organische Leuchtdiode (OLED), organische Laserdiode (O-Laser) oder organisches photovoltaisches (OPV) Element oder Vorrichtung handelt.

14. Organische Leuchtdiode nach Anspruch 13, **dadurch gekennzeichnet, dass** diese eine oder mehrere Schichten enthält, wobei mindestens eine dieser Schichten ein oder mehrere Polymere, oder Blends nach mindestens einem der Ansprüche 1 bis 9 enthält.

## Claims

1. Conjugated polymers, **characterised in that** they contain one or more units of the formula (1) 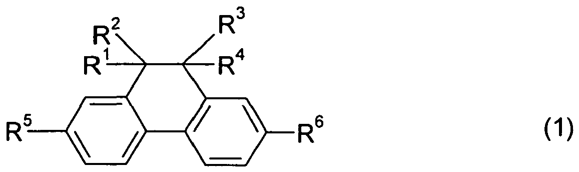 in which
R¹⁻⁴ on each occurrence, identically or differently, denote F or a straight-chain, branched or cyclic alkyl, alkenyl or alkynyl group, in which, in addition, one or more H atoms may be replaced by fluorine, or an aryl, aralkyl, aralkenyl, aralkynyl or heteroaryl group, which may also be mono- or polysubstituted,
R^{5,6} denote a link in the polymer.

2. Polymers according to Claim 1, **characterised in that** the units of the formula (1) are incorporated into the main chain of the polymer.

3. Polymers according to Claim 1 or 2, **characterised in that** the radicals R¹⁻⁴ are selected from the group comprising C₁-C₄₀ alkyl, C₂-C₄₀ alkenyl, C₂-C₄₀ alkynyl, C₃-C₄₀ allyl, C₄-C₄₀ alkyldienyl, C₄-C₄₀ polyenyl, C₆-C₄₀ aryl, C₆-C₄₀ alkylaryl, C₆-C₄₀ arylalkyl, C₆-C₄₀ heteroaryl, C₄-C₄₀ cycloalkyl and C₄-C₄₀ cycloalkenyl.

4. Polymers according to at least one of Claims 1 to 3, **characterised in that** the units of the formula (1) are selected from the following sub-formulae: 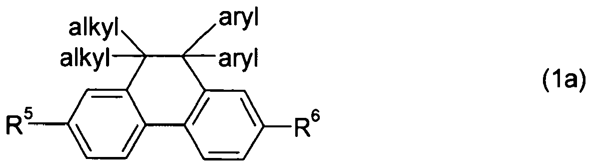 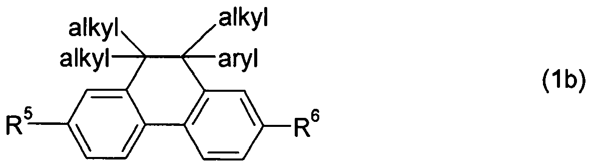 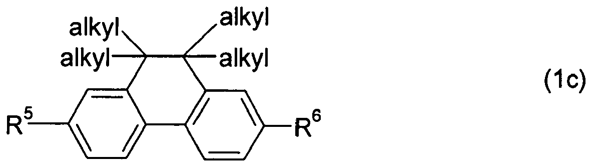 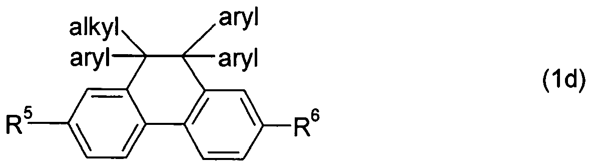 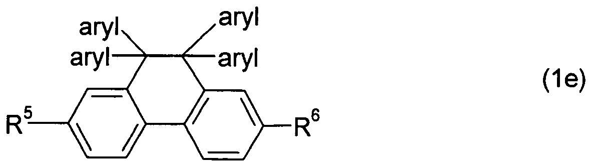 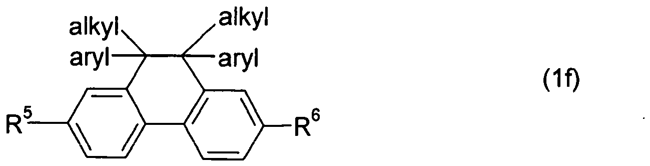 in which R¹, R², R⁵ and R⁶ have the meaning indicated in Claim 1,
"alkyl" on each occurrence, identically or differently, denotes a straight-chain, branched or cyclic alkyl radical having 1 to 20 C atoms,
"aryl" on each occurrence, identically or differently, denotes an optionally substituted aryl radical having 5 to 20 C atoms or heteroaryl radical having 3 to 20 C atoms.

5. Polymers according to at least one of Claims 1 to 4, **characterised in that** they contain further structural elements selected from the groups of the fluorenylenes, spirobifluorenylenes, tetrahydropyrenylenes, stilbenylenes, bisstyrylarylenes, 1,4-phenylenes, 1,4-naphthylenes, 1,4- or 9,10-anthrylenes, 1,6- or 2,7- or 4,9-pyrenylenes, 3,9- or 3,10-perylenylenes, 2,7- or 3,6-phenanthrenylenes, 4,4'-bi-phenylylenes, 4,4"-terphenylylenes or 4,4'-bi-1,1'-naphthylylenes.

6. Polymers according to at least one of Claims 1 to 5, **characterised in that** they contain further structural elements selected from the groups of the triarylamines, triarylphosphines, benzidines, tetraarylene-paraphenylenediamines, phenothiazines, phenoxazines, dihydrophenazines, thianthrenes, dibenzo-p-dioxins, phenoxathiynes, carbazoles, azulenes, thiophenes, pyrroles or furans.

7. Polymers according to at least one of Claims 1 to 6, **characterised in that** they contain further structural elements selected from the groups of the pyridines, pyrimidines, pyridazines, pyrazines, anthracenes, triarylboranes, oxadiazoles, quinolines, quinoxalines, phenazines, ketones, phosphine oxides, sulfoxides or triazines.

8. Polymers according to at least one of Claims 1 to 7, **characterised in that** the proportion of the structural units of the formula (1) is 10 to 99 mol%.

9. Blend of one or more polymers according to at least one of Claims 1 to 8 with one or more further polymeric, oligomeric, dendritic or low-molecular-weight substances.

10. Solutions and formulations comprising one or more polymers or blends according to the invention according to at least one of Claims 1 to 9 in one or more solvents.

11. Use of polymers, blends, solutions or formulations according to at least one of Claims 1 to 10 in an electronic component, preferably in an organic light-emitting diode (OLED).

12. Electronic component comprising one or more polymers, blends, solutions or formulations according to at least one of Claims 1 to 10.

13. Electronic component according to Claim 12, **characterised in that** it is a field-effect transistor (OFET), organic thin-film transistor (O-TFT), organic integrated circuit (O-IC), organic solar cell (O-SC), organic light-emitting diode (OLED), organic laser diode (O-laser) or organic photovoltaic (OPV) element or device.

14. Organic light-emitting diode according to Claim 13, **characterised in that** it comprises one or more layers, where at least one of these layers comprises one or more polymers or blends according to at least one of Claims 1 to 9.

## Revendications

1. Polymères conjugués, **caractérisés en ce qu'**ils contiennent une ou plusieurs unités de la formule (1) 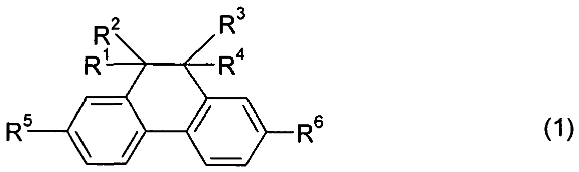 dans laquelle
R¹⁻⁴ représentent, pour chaque occurrence, de manière identique ou différente, F ou un groupe alkyle, alkényle ou alkynyle en chaîné droite, ramifié ou cyclique, où, en outre, un ou plusieurs atomes de H peut/peuvent être remplacé(s) par fluor, ou un groupe aryle, aralkyle, aralkényle, aralkynyle ou hétéroaryle, lequel peut également être mono- ou polysubstitué,
R^{5,6} représentent une liaison dans le polymère.

2. Polymères selon la revendication 1, **caractérisés en ce que** les unités de la formule (1) sont incorporées dans la chaîne principale du polymère.

3. Polymères selon la revendication 1 ou 2, **caractérisés en ce que** les radicaux R¹⁻⁴ sont choisis parmi le groupe comprenant C₁-C₄₀ alkyle, C₂-C₄₀ alkényle, C₂-C₄₀ alkynyle, C₃-C₄₀ allyle, C₄-C₄₀ alkyldiényle, C₄-C₄₀ polyényle, C₆-C₄₀ aryle, C₆-C₄₀ alkylaryle, C₆-C₄₀ arylalkyle, C₆-C₄₀ hétéroaryle, C₄-C₄₀ cycloalkyle et C₄-C₄₀ cycloalkényle.

4. Polymères selon au moins l'une des revendications 1 à 3, **caractérisés en ce que** les unités de la formule (1) sont choisies parmi les sous-formules qui suivent : 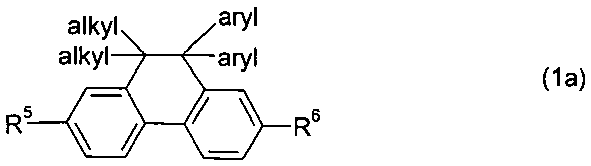 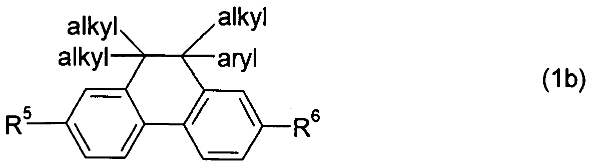 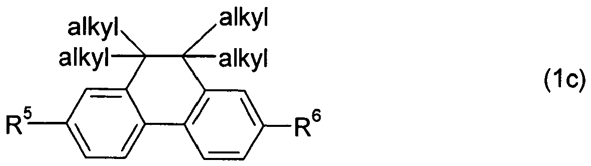 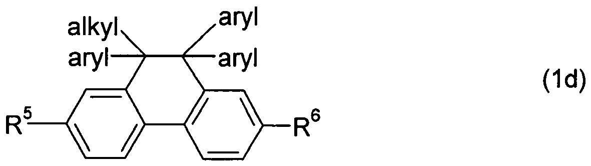 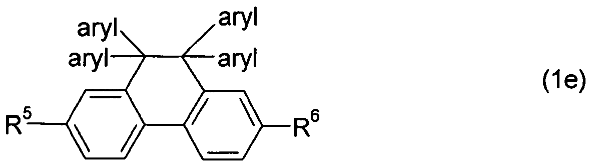 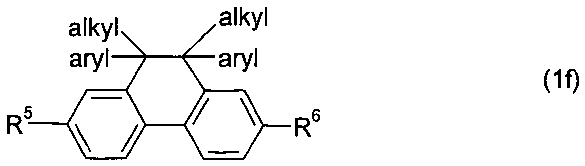 dans lesquelles R¹, R², R⁵ et R⁶ présentent la signification indiquée selon la revendication 1,
"alkyl" représente, pour chaque occurrence, de manière identique ou différente, un radical alkyle en chaîne droite, ramifié ou cyclique comportant de 1 à 20 atomes de C, .
"aryl" représente, pour chaque occurrence, de manière identique ou différente, un radical aryle en option substitué comportant de 5 à 20 atomes de C ou un radical hétéroaryle comportant de 3 à 20 atomes de C.

5. Polymères selon au moins l'une des revendications 1 à 4, **caractérisés en ce qu'**ils contiennent d'autres éléments structurels choisis parmi les groupes des fluorénylènes, spirobifluorénylènes, tétra-hydropyrénylènes, stilbénylènes, bisstyrylarylènes, 1,4-phénylènes, 1,4-naphtylènes, 1,4- ou 9,10-anthrylènes, 1,6- ou 2,7- ou 4,9-pyrénylènes, 3,9- ou 3,10-pérylénylènes, 2,7- ou 3,6-phénanthrénylènes, 4,4'-biphénylylènes, 4,4"-terphénylylènes ou 4,4'-bi-1,1'-naphtylylènes.

6. Polymères selon au moins l'une des revendications 1 à 5, **caractérisés en ce qu'**ils contiennent d'autres éléments structurels choisis parmi les groupes des triarylamines, triarylphosphines, benzidines, tétraarylène-para-phénylènediamines, phénothiazines, phénoxazines, dihydrophénazines, thianthrènes, dibenzo-p-dioxines, phénoxathiynes, carbazoles, azulènes, thiophènes, pyrroles ou furanes.

7. Polymères selon au moins l'une des revendications 1 à 6, **caractérisés en ce qu'**ils contiennent d'autres éléments structurels choisis parmi les groupes des pyridines, pyrimidines, pyridazines, pyrazines, anthracènes, triarylboranes, oxadiazoles, quinolines, quinoxalines, phénazines, cétones, oxydes de phosphine, sulfoxydes ou triazines.

8. Polymères selon au moins l'une des revendications 1 à 7, **caractérisés en ce que** la proportion des unités structurelles de la formule (1) est de 10 à 99 mol%.

9. Mélange d'un ou de plusieurs polymères selon au moins l'une des revendications 1 à 8 avec une ou plusieurs autres substances polymériques, oligomériques, dendritiques ou de poids moléculaire-faible.

10. Solutions et formulations comprenant un ou plusieurs polymères ou mélanges selon l'invention selon au moins l'une des revendications 1 à 9 dans un ou plusieurs solvants.

11. Utilisation de polymères, de mélanges, de solutions ou de formulations selon au moins l'une des revendications 1 à 10 dans un composant électronique, de préférence dans une diode émettrice de lumière organique (OLED).

12. Composant électronique comprenant un ou plusieurs polymères, mélanges, solutions ou formulations selon au moins l'une des revendications 1 à 10.

13. Composant électronique selon la revendication 12, **caractérisé en ce qu'**il s'agit d'un transistor à effet de champ (OFET), d'un transistor à film mince organique (O-TFT), d'un circuit intégré organique (O-IC), d'une cellule solaire organique (O-SC), d'une diode émettrice de lumière organique (OLED), d'une diode laser organique (O-laser) ou d'un élément ou dispositif photovoltaïque organique (OPV).

14. Diode émettrice de lumière organique selon la revendication 13, **caractérisée en ce qu'**elle comprend une ou plusieurs couches, où au moins l'une de ces couches comprend un ou plusieurs polymères ou mélanges selon au moins l'une des revendications 1 à 9.
